# EUROPÄISCHE PATENTSCHRIFT

(11) **EP 0 406 534 B1**
(45) Veröffentlichungstag und Bekanntmachung des Hinweises auf die Patenterteilung: **14.09.1994**
(21) Anmeldenummer: 90108159.6
(22) Anmeldetag: 28.04.1990
(51) Int. Cl.: H05K 3/00, B65G 49/04, B23K 3/06

(54) **Vorrichtung zum Behandeln von plattenförmigen Gegenständen**
Device for treating plate-shaped articles
Dispositif pour le traitement d'objets en forme de plaques

(30) Priorität: 05.07.1989 DE 3922056
(43) Veröffentlichungstag der Anmeldung: 09.01.1991
(73) Patentinhaber: Gebr. Schmid GmbH & Co., D-72250 Freudenstadt (DE)
(72) Erfinder: Kallfass, Karl-Heinz, D-7292 Baiersbronn 6, Klosterreichenbach (DE)
(74) Vertreter: Patentanwälte Ruff, Beier, Schöndorf und Mütschele

(56) Entgegenhaltungen:
- DE-A- 2 343 524
- DE-B- 2 420 824

## Beschreibung

Die Erfindung betrifft eine Vorrichtung zum Behandeln von plattenförmigen Gegenständen in einem flüssigen Medium, wobei die Vorrichtung ein das flüssige Medium enthaltendes Bad umfaßt, welches unterhalb des Flüssigkeitsspiegels angeordnete spaltartige Ein- und/oder Austrittsöffnungen umfaßt, und wobei die Vorrichtung eine Transportvorrichtung zum Fördern der plattenförmigen Gegenstände entlang eines im wesentlichen ebenen Transportweges durch die Ein- bzw. Austrittsöffnungen und das flüssige Medium im Bad hindurch umfaßt.

Solche Vorrichtungen sind beispielsweise als Ätzmaschinen zur Behandlung von Leiterplatten oder auch als Heißverzinnungsanlagen bekannt, bei denen ebenfalls Leiterplatten als plattenförmige Gegenstände durch ein flüssiges Medium, welches hier von Lot gebildet wird, transportiert werden, um in diesem Fall einen Auftrag des Lotes auf die Leiterbahnen und/oder an den Durchkontaktierungsstellen zu erhalten.

Um eine gleichzeitige Behandlung der Ober- und Unterseiten der plattenförmigen Gegenstände, insbesondere der Leiterplatten, zu erreichen, ist es notwendig, daß die plattenförmigen Gegenstände, in der folgenden Beschreibung und Diskussion verkürzt mit Leiterplatten bezeichnet, unterhalb des Flüssigkeitsspiegels des flüssigen Mediums in dem Behandlungsbad geführt werden (siehe zum Beispiel DE-A- 2 343 524).

Wegen der häufig anzutreffenden Empfindlichkeit bei der mechanischen Beanspruchung der Leiterplatten wird der Transportweg der Leiterplatten möglichst in einer Ebene durchgeführt, weshalb dann zumindest die Ein- oder die Austrittsöffnung des Bades unterhalb des Flüssigkeitsspiegels des flüssigen Mediums im Badbehälter angeordnet sein muß.

Bei den bisher bekanntgewordenen Vorrichtungen zum Behandeln von Leiterplatten in einem flüssigen Medium wurden die Ein- und Austrittsöffnungen durch Walzenpaare gebildet, die drehbar quer zur Transportrichtung angeordnet sind und zwischen sich nur eine Spaltöffnung freigeben, die der Dicke der Leiterplatte entspricht.

Da die Vorrichtungen zum Behandeln der Leiterplatten mit einem flüssigen Medium möglichst universell für alle vorkommenden Leiterplattengrößen einsetzbar sein sollen, war es notwendig, die Breite der Walzen und damit auch die Breite der Spaltöffnung bei der Ein- oder Austrittsöffnung so breit zu machen, daß die größte zu bearbeitende Leiterplatte ohne Behinderung in das Bad eingefördert bzw. aus dem Bad wieder herausgefördert werden konnte.

Bei wechselnden Breiten der zu behandelnden Leiterplatten blieben dann die Spalte in mehr oder weniger großem Umfang beim Durchtritt einer Platte seitlich hiervon offen, und das flüssige Medium des Bades ist in mehr oder weniger großem Umfang aus dem Badbehälter ausgetreten und mußte über geeignete Fördervorrichtungen wieder in das eigentliche Bad zurückgefördert werden. Bei den heute üblichen Leiterplatten, insbesondere bei den Multi-Layer-Platten, kommen Plattenstärken bis zu 10 mm vor, die dann bei relativ geringen Plattenbreiten zu einem großen Verlust an flüssigem Medium in dem eigentlichen Badbehälter führen, der nur durch eine entsprechende Dimensionierung der Rückfördervorrichtungen für das flüssige Medium ausgeglichen werden kann.

Da die Kleinserienfertigung in der Leiterplattenproduktion immer mehr an Bedeutung gewinnt, das heißt also auch die Flexibilität in der Produktion verschiedener Leiterplatten in kurzen Zeitabständen, stellt sich ausgehend von der zuvor geschilderten Problematik die Erfindung die Aufgabe, eine Vorrichtung zum Behandeln von plattenförmigen Gegenständen in einem flüssigen Medium vorzuschlagen, bei der die Flüssigkeitsverluste aus dem Bad deutlich verringert sind.

Diese Aufgabe wird bei einer Vorrichtung der eingangs beschriebenen Art erfindungsgemäß dadurch gelöst, daß die Ein- und/oder Austrittsöffnungen Abdichtelemente umfassen, welche von einer Schließ- in eine Offenposition beim Durchtritt der plattenförmigen Gegenstände bewegbar sind und die weiterhin so ausgebildet sind, daß der sich in der Offenposition der Abdichtelemente ergebende Spalt in Höhe und Breite zur Anpassung an den Querschnitt der durchtretenden Gegenstände veränderbar ist.

Konstruktiv besonders einfach sind solche Ausführungsformen, bei denen die, in Transportrichtung gesehen, vordere Kante der plattenförmigen Gegenstände, insbesondere der Leiterplatten, durch mechanischen Kontakt mit den Abdichtelementen diese in die Offenposition bewegt. Dies könnte zum Beispiel durch eine mechanische Abtastung der Plattenbreite und eine damit synchron laufende Einstellung der Spaltbreite geschehen. Als besonders günstig hat es sich jedoch erwiesen, wenn die Abdichtelemente eine Vielzahl von um eine gemeinsame Achse quer zur Transportrichtung verschwenkbare, parallel zueinander angeordnete Dichtungssegmente umfassen. Diese Dichtungssegmente ragen in der Schließposition in den Transportweg der Leiterplatten hinein und werden dadurch beim Weitertransport der Leiterplatten von der Plattenkante angehoben und in die Offenposition verschwenkt. Die sich hierbei ergebende Spaltöffnung wird gleichzeitig von der Vorderkante der Leiterplatte abgedeckt, so daß es nur in unwesentlichem Umfang zu einem Austritt des flüssigen Mediums aus dem Bad kommt.

Als Gegenlager für die Abdichtelemente und als Bestandteil der Ein- bzw. Austrittsöffnungen empfiehlt es sich, eine, gegebenenfalls antreibbare, quer zur Transportrichtung angeordnete Walze unterhalb der Transportebene vorzusehen, die bei den Ein- bzw. Austrittsöffnungen die Leiterplatten unterstützt und gegebenenfalls aktiv transportiert.

Die verschwenkbaren Dichtungssegmente liegen in ihrer Schließposition dichtend an der Walze an.

Um eine geringere Reibung zwischen den Dichtungssegmenten und damit eine leichtere Verschwenkbarkeit der Segmente zu erreichen, kann vorgesehen sein, daß die Dichtungssegmente in einem geringen seitlichen Abstand zueinander angeordnet sind. Dabei ist darauf zu achten, daß die Oberflächenspannung der in dem Bad verwendeten flüssigen Medien gegenüber dem für die Dichtungssegmente verwendeten Material so groß ist, daß im wesentlichen keine Flüssigkeit durch die Spalte aus dem Bad austreten kann.

Bei einer der bevorzugten Ausführungsformen werden die Dichtungssegmente in ihrer Verschwenkbewegung in Richtung zur Schließposition hin, beispielsweise durch Federelemente, vorgespannt.

Zusätzlich oder alternativ hierzu kann die Schwenkachse der Dichtungssegmente in einem Abstand zum Schwerpunkt der Segmente angeordnet sein, so daß sich allein von dieser Anordnung her die Dichtungssegmente selbsttätig in Richtung zur Schließposition bewegen, wenn die spezifische Dichte des Segmentmaterials größer ist als die der in dem Bad enthaltenen Flüssigkeit.

Selbstverständlich kann die Schließwirkung der Dichtungssegmente durch das Anbringen von Gewichten im Abstand zur Schwenkachse verstärkt werden. Alternativ hierzu wäre beispielsweise bei den Dichtungssegmenten, die an der Austrittsöffnung angeordnet sind, eine Hohlkammer vorstellbar, die an einem Ende der Segmente einen Auftrieb in dem Medium bewirkt und damit ebenfalls zu einer Vergrößerung der Rückstellkraft der Dichtungssegmente in Richtung zur Schließposition hin führt.

Diese und weitere Vorteil der Erfindung sind im folgenden anhand der Zeichnung noch näher erläutert. Es zeigen im einzelnen:
- Fig. 1: eine schematische Seitenansicht einer erfindungsgemäßen Vorrichtung

und
- Fig. 2: eine perspektivische Detailansicht einer Eintrittsöffnung einer erfindungsgemäßen Vorrichtung.

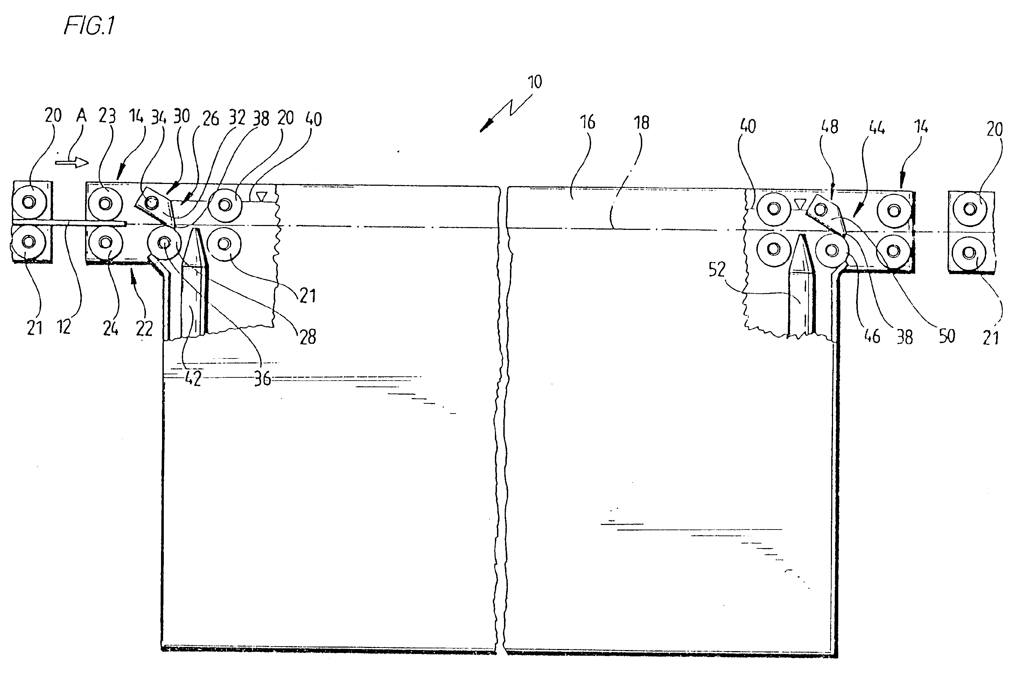

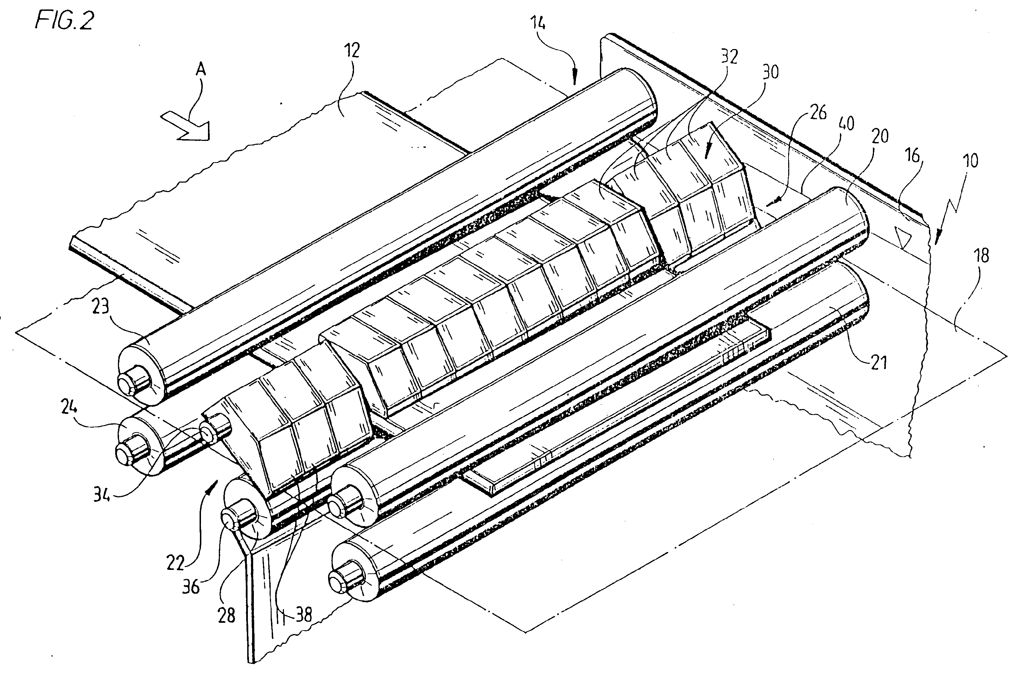

Fig. 1 zeigt eine als Ganzes mit dem Bezugszeichen 10 gekennzeichnete Vorrichtung zum Behandeln von plattenförmigen Gegenständen in einem flüssigen Medium oder einer sogenannten Badstation, bei der plattenförmige Gegenstände 12, im folgenden kurz Leiterplatten genannt, über eine Transportvorrichtung 14 in einen Badbehälter 16 eingefördert werden. Die Transportebene, die durch die Transportvorrichtung 14 für die Leiterplatten 12 definiert wird, ist mit dem Bezugszeichen 18 gekennzeichnet (strichpunktierte Linie in Fig. 1 bzw. Flächendarstellung in Fig. 2).

Die Transportvorrichtung 14 besteht aus einer Vielzahl von Walzenpaaren 20, 21, welche zum Teil angetrieben sind und zum Teil als Schleppwalzen mit den geförderten Leiterplatten mitlaufen.

Ein Eingangsbereich 22 der Badstation, der in Fig. 2 zusätzlich im Detail dargestellt ist, umfaßt Führungswalzen 23, 24, die übereinander angeordnet sind und den in die Badstation einlaufenden Leiterplatten 12 eine definierte Führung in Richtung zu einer Eintrittsöffnung 26 geben.

Die Eintrittsöffnung 26 umfaßt eine Walze 28, welche quer zur Transportrichtung und unterhalb der Transportebene 18 angeordnet ist und die als Gegenlager für ein Abdichtelemente 30 dient. Das Abdichtelement 30 umfaßt eine Vielzahl von Abdichtsegmenten 32, welche um eine Achse 34 in einer zur Transportebene 18 senkrechten Ebene verschwenkbar sind. Die Achse 34 ist dabei parallel zur Drehachse 36 der Walze 28 angeordnet.

Dadurch, daß die Dichtungssegmente 32 außerhalb ihres Schwerpunktes drehbar von der Achse 34 gehalten sind, bewegen sich die dichtenden Enden 38 der Segmente 32 selbsttätig in Richtung zur darunterliegenden Walze 28 und bilden so eine Abdichtung der Eintrittsöffnung 26.

Der Flüssigkeitsspiegel im Badbehälter 16 ist mit dem Bezugszeichen 40 gekennzeichnet und liegt oberhalb der Transportebene 18 und kann von dieser bis in etwa zu einem Abstand angehoben werden, der dem Durchmesser der Transportwalzen 20 bzw. Führungswalzen 23 entspricht.

Direkt anschließend an den Einlaufbereich können Zulaufdüsen 42 angeordnet sein, die die eintretenden Leiterplatten 12 mit frischem Medium bespülen.

Die Grundform der Dichtungssegmente 32 kann den räumlichen Gegebenheiten angepaßt werden und ist in den dargestellten Ausführungsformen als abgeschrägter Quader gezeigt. Die Abschrägung hat den Vorteil, daß bei der Verschwenkbewegung der Dichtungssegmente 32 oberhalb der Transportebene nicht allzuviel Raum für die Ausweichbewegung der Segmente in die Offenstellung benötigt wird.

Die Dichtungssegmente können an ihren auf der Walze 28 aufliegenden Enden 38 mit zusätzlichen Gewichten versehen sein, so daß die Segmente selbst aus einem relativ leichten Material hergestellt werden können und trotzdem, selbst bei einem Medium mit einem größeren spezifischen Gewicht, eine gute Abdichtwirkung erzielt wird. Bevorzugt wird jedoch ein Material für die Segmente 32, das von Haus aus eine Dichte aufweist, die um den Faktor 1,5 bis 2 größer ist als die Dichte des Mediums.

Auf der Auslaufseite der Badstation 16 ist eine Austrittsöffnung 44 angeordnet, welche im Prinzip analog zu der Eintrittsöffnung 26 aufgebaut und ausgebildet ist. Eine Walze 46 bildet hier das Gegenlager für ein Abdichtelement 48, das sich aus Dichtungssegmenten 50 zusammensetzt, welche mit ihrem verschwenkbaren Ende dichtend auf der Walze 46 aufliegen. Die Walze 46 grenzt mit ihrer Umfangsfläche unterhalb der Transportebene 18 an die Wandung des Badbehälters 16 an und bildet im Bereich der Austrittsöffnung 44 zusammen mit dem Abdichtelement 48 den oberen Abschluß des Badbehälters 16. Eine entsprechende Anordnung und Auslegung der Eintrittsöffnung 26, bei der die Walze 28 in dichtendem Kontakt mit der Wandung des Badbehälters 16 steht, sorgt auf seiten der Eintrittsöffnung 26 dafür, daß dort ein Flüssigkeitsspiegel 40 bis über die Transportebene 18 hinaus aufrechterhalten werden kann.

Kurz vor der Austrittsöffnung 44 ist im Badbehälter 16 eine weitere Düse 52 angeordnet, über die sich eine definierte Zirkulation des flüssigen Mediums im Badbehälter 16 im Auslaufbereich des Badbehälters herstellen läßt, so daß eine Spülung der die Behandlungsvorrichtung verlassenden Leiterplatten 12 erfolgt.

Wie am besten aus Fig. 2 zu ersehen ist, werden die Abdichtsegmente 32 (bzw. 50) durch eine sich in Transportrichtung (Pfeil A) bewegende Leiterplatte 12 aus ihrer Ruheposition, die gleichzeitig die Schließposition der Ein- und Austrittsöffnungen darstellt, in eine Offenposition bewegt. Die Verschwenkung der Abdichtsegmente 32, 50 erfolgt mechanisch durch das Einfahren der Leiterplatte 12 mit ihrer Vorderkante in die Ein- bzw. Austrittsöffnung 26, 44, wobei nur entsprechend der Breite der Leiterplatte eine Spaltöffnung freigegeben wird. Die restlichen Segmente 32, 50 verbleiben in ihrer Ruhestellung und verhindern so ein übermäßiges Austreten der Flüssigkeit aus dem Badbehälter 16. Eine zufriedenstellende Abdichtwirkung wird beispielsweise mit Segmentbreiten (in Richtung quer zur Transportrichtung gesehen) von ca. 1 cm erzielt. Mit der erfindungsgemäßen Vorrichtung wird gleichzeitig neben einer optimalen Spaltbreite auch die optimale Spalthöhe eingestellt, da während dem Ein- bzw. Austreten der Leiterplatten 12 in bzw. aus dem Badbehälter 16 eine Spaltöffnung in der Höhe nur insofern freigegeben wird, als dies dem Querschnitt der Leiterplatte 12 entspricht.

Die nur noch unwesentlichen Anteile der austretenden Badflüssigkeit werden in einem Auffangbecken (nicht dargestellt) aufgefangen und über eine Umwälzvorrichtung dem Badbehälter 16 erneut zugeführt. Dies bedeutet keinen größeren Aufwand, da eine Umwälzung der Badflüssigkeit im Badbehälter 16 in jedem Fall erforderlich ist.

Selbstverständlich ist vorstellbar, daß die Transportebene 18 gegenüber der Horizontalen leicht geneigt sein kann, so daß entweder nur die Eintrittsöffnung 26 oder die Austrittsöffnung 44 unterhalb des Flüssigkeitsspiegels 40 zu liegen kommt. In diesen Fällen ist jeweils nur im Bereich der Eintrittsöffnung (26) bzw. der Austrittsöffnung 44 eine Abdichtung in der erfindungsgemäßen Weise erforderlich. Bevorzugt werden jedoch solche Vorrichtungen, bei denen die Transportebene im wesentlichen horizontal verläuft, da sich so eine einfache Eingliederung in restliche Produktionsprozesse und Behandlungsvorrichtungen, wie sie für die Herstellung von Leiterplatten benötigt werden, vornehmen läßt.

Das flüssige Medium in dem Badbehälter 16 kann beispielsweise eine Ätzlösung sein, mit der überschüssige Kupferanteile von der Oberfläche der Leiterplatten abgeätzt werden, es kann jedoch gänzlich andere Medien, wie zum Beispiel Flußmittel, enthalten oder aber flüssiges Lot, wie zum Beispiel bei einer Heißverzinnungsanlage.

Das Material, aus dem die Segmente 32, 50 hergestellt sind, richtet sich zum einen nach der Betriebstemperatur der Badstationen 10 und zum anderen natürlich nach der spezifischen Dichte des verwendeten flüssigen Mediums. Im Falle einer Heißverzinnungsanlage, wo das flüssige Medium eine relativ hohe Dichte aufweist, kann es empfehlenswert sein, die Dichtungssegmente 32, 50 in Richtung der Schließstellung vorzuspannen.

Bei der Ausgestaltung der Abdichtsegmente 32, 50 ist weiterhin wichtig, daß diese an der mit den Leiterplatten in Berührung kommenden Oberfläche eine möglichst geringe Oberflächenrauigkeit aufweisen, so daß Beschädigungen der durch die Eintritts- bzw. Austrittsöffnung hindurchgleitenden Leiterplatten 12 an der Oberfläche möglichst vermieden werden.

In vielen Fällen, in denen flüssige Medien zum Einsatz gelangen, kann als Material für die Abdichtsegmente 32, 50 ein entsprechend ausgewählter Kunststoff verwendet werden. Hier beobachtet man häufig eine spezifische Dichte zwischen 1,5 und 2.0, so daß das Eigengewicht der Segmente für das selbsttätige Verschwenken der Segmente in die Ruheposition und damit für die Abdichtwirkung ausreichend ist.

## Patentansprüche

1. Vorrichtung (10) zum Behandeln von plattenförmigen Gegenständen (12) in einem flüssigen Medium, wobei die Vorrichtung ein das flüssige Medium enthaltendes Bad mit unterhalb des Flüssigkeitsspiegels angeordneten spaltartigen Ein- und/oder Austrittsöffnungen (26, 44) umfaßt, und wobei die Vorrichtung eine Transportvorrichtung (14) umfaßt, zum Fördern der plattenförmigen Gegenstände entlang eines im wesentlichen ebenen Transportweges durch die Ein- und/oder Austrittsöffnungen und das flüssige Medium im Bad hindurch, **dadurch gekennzeichnet**, daß die Ein- und/oder Austrittsöffnungen (26; 44) Abdichtelemente (30; 48) umfassen, welche von einer Schließ- in eine Offenstellung beim Durchtritt der plattenförmigen Gegenstände (12) bewegbar sind und die weiterhin so ausgebildet sind, daß der sich in der Offenstellung der Abdichtelemente (30; 48) ergebende Spalt in Höhe und Breite zur Anpassung an den Querschnitt der durchtretenden Gegenstände (12) veränderbar ist.

2. Vorrichtung nach Anspruch 1, dadurch gekennzeichnet, daß die Abdichtelemente (30; 48) eine Vielzahl um eine gemeinsame Achse (34) verschwenkbarer, parallel zueinander angeordneter Dichtungssegmente (32; 50) umfassen.

3. Vorrichtung nach Anspruch 1 oder 2, dadurch gekennzeichnet, daß die Ein- bzw. Austrittsöffnungen (26; 44) eine, gegebenenfalls antreibbare, Walze (28; 46) als Gegenlager für die Abdichtelemente (30; 48) umfassen.

4. Vorrichtung nach Anspruch 3, dadurch gekennzeichnet, daß die verschwenkbaren Abdichtelemente (30; 48) in der Schließstellung dichtend an der Walze (28; 46) anliegen.

5. Vorrichtung nach einem oder mehreren der Ansprüche 2 bis 4, dadurch gekennzeichnet, daß die verschwenkbaren Dichtungssegmente (32; 50) in einem geringen seitlichen Abstand zueinander angeordnet sind.

6. Vorrichtung nach einem oder mehreren der Ansprüche 2 bis 5, dadurch gekennzeichnet, daß die Abdichtelemente (30; 48) in Richtung zur Schließstellung vorgespannt sind.

7. Vorrichtung nach einem oder mehreren der Ansprüche 2 bis 6, dadurch gekennzeichnet, daß die Schwenkachse (34) der Dichtungssegmente (32; 50) in einem Abstand zum Schwerpunkt der Segmente (32; 50) angeordnet ist.

## Claims

1. Apparatus (10) for treating plate-shaped articles (12) in a liquid medium, said apparatus comprising a bath containing said liquid medium with gap-like inlet and/or outlet openings (26,44) arranged beneath the liquid level, and said apparatus further comprising a conveying device (14) for conveying said plate-shaped articles along a substantially flat path of conveyance through said inlet and/or outlet openings and through said liquid medium in said bath, characterized in that said inlet and/or outlet openings (26;44) comprise sealing elements (30;48) which are movable from a closed to an open position as said plate-shaped articles (12) pass through them and which are furthermore of such design that the gap created by said sealing elements (30;48) in their open position is variable as regards height and width to adapt to the cross-section of said articles (12) passing through it.

2. Apparatus according to claim 1, characterized in that said sealing elements (30;48) comprise a plurality of sealing segments (32;50) arranged parallel to one another and pivotable about a common axis (34).

3. Apparatus according to claim 1 or 2, characterized in that said inlet and outlet openings (26;44) comprise as abutment for said sealing elements (30;48) a roll (28;46) which, if appropriate, may be drivable.

4. Apparatus according to claim 3, characterized in that said pivotable sealing elements (30;48) rest in their closed position sealingly against said roll (28;46).

5. Apparatus according to one or more of the claims 2 to 4, characterized in that said pivotable sealing segments (32,50) are spaced laterally at a slight distance from one another.

6. Apparatus according to one or more of the claims 2 to 5, characterized in that said sealing elements (30;48) are pretensioned in the direction towards the closed position.

7. Apparatus according to one or more of the claims 2 to 6, characterized in that said pivot axis (34) of said sealing segments (32; 50) is spaced from the centre of gravity of said segments (32;50).

## Revendications

1. Dispositif (10) pour traiter des objets en forme de plaques (12) dans un milieu liquide, le dispositif comprenant une cuve qui contient le milieu liquide et qui comprend des ouvertures d'entrée et/ou de sortie (26 ; 44) en forme de fentes disposées au-dessous du niveau du liquide, et le dispositif comprenant un dispositif de transport (14) destiné à déplacer les objets en forme de plaques à travers les ouvertures d'entrée et/ou de sortie et à travers le milieu liquide contenu dans la cuve, le long d'un trajet de transport qui est plan pour l'essentiel, caractérisé par le fait que les ouvertures d'entrée et/ou de sortie (26 ; 44) comprennent des organes d'étanchéité (30 ; 48) qui peuvent être déplacés depuis une position de fermeture jusque dans une position d'ouverture lors du passage des objets en forme de plaques (12) et qui sont en outre conformés d'une manière telle que la fente formée dans la position d'ouverture des organes d'étanchéité (30 ; 48) puisse être modifiée quant à sa hauteur et à sa largeur, en vue de son adaptation à la section transversale des objets (12) qui passent à travers elle.

2. Dispositif selon la revendication 1, caractérisé par le fait que les organes d'étanchéité (30 ; 48) comprennent une pluralité d'éléments d'étanchéité (32 ; 50) qui peuvent pivoter autour d'un axe commun (34) et qui sont disposés parallèlement entre eux.

3. Dispositif selon la revendication 1 ou 2, caractérisé par le fait que les ouvertures d'entrée et/ou de sortie (26 ; 44) comprennent un rouleau (28 ; 46) qui peut être éventuellement entraîné et qui sert de contre-appui aux organes d'étanchéité (30 ; 48).

4. Dispositif selon la revendication 3, caractérisé par le fait que les organes d'étanchéité pivotants (30 ; 48) portent d'une manière étanche sur le rouleau (28 ; 46) dans la position de fermeture.

5. Dispositif selon l'une ou plusieurs des revendications 2 à 4, caractérisé par le fait que les éléments d'étanchéité pivotants (32 ; 50) sont disposés à une faible distance les uns des autres dans le sens latéral.

6. Dispositif selon l'une ou plusieurs des revendications 2 à 5, caractérisé par le fait que les organes d'étanchéité (30 ; 48) sont rappelés dans la direction de la position de fermeture.

7. Dispositif selon l'une ou plusieurs des revendications 2 à 6, caractérisé par le fait que l'axe de pivotement (34) des éléments d'étanchéité (32 ; 50) est disposé à distance du centre de gravité de ces éléments (32 ; 50).
